Europäisches Patentamt

(19) European Patent Office

Office européen des brevets

(11) Numéro de publication: **0 128 617**
**B1**

(12) # FASCICULE DE BREVET EUROPEEN

(45) Date de publication du fascicule du brevet:
**26.08.87**

(51) Int. Cl.⁴: **H 03 G 3/34**

(21) Numéro de dépôt: **84200775.9**

(22) Date de dépôt: **29.05.84**

(54) **Dispositif de silencieux pour récepteur radio AM/FM.**

(30) Priorité: **01.06.83 FR 8309073**

(43) Date de publication de la demande:
**19.12.84 Bulletin 84/51**

(45) Mention de la délivrance du brevet:
**26.08.87 Bulletin 87/35**

(84) Etats contractants désignés:
**DE FR GB IT**

(56) Documents cités:
**DE - A - 2 152 373**
**DE - B - 1 282 746**
**FR - A - 1 585 427**
**US - A - 3 728 634**
**US - A - 3 979 679**

(73) Titulaire: **TELECOMMUNICATIONS
RADIOELECTRIQUES ET TELEPHONIQUES T.R.T.,
88, rue Brillat Savarin, F-75013 Paris (FR)**

(84) Etats contractants désignés: **FR**

(73) Titulaire: **N.V. Philips' Gloeilampenfabrieken,
Groenewoudseweg 1, NL-5621 BA Eindhoven (NL)**

(84) Etats contractants désignés: **DE GB IT**

(72) Inventeur: **Faugeron, Gabriel Sociète Civile S.P.I.D.,
209 rue de l'Université, F-75007 Paris (FR)**

(74) Mandataire: **Chaffraix, Jean et al, Société Civile
S.P.I.D. 209, rue de l'Université, F-75007 Paris (FR)**

## Description

L'invention concerne un dispositif de silencieux pour récepteur radio muni d'un démodulateur AM et d'un démodulateur FM pour le fonctionnement du récepteur en modulation de fréquence ou en modulation d'amplitude, ce dispositif de silencieux comportant un circuit de mesure du niveau de bruit connecté à la sortie du démodulateur FM pour fournir un signal de bruit lors du fonctionnement du récepteur en modulation d'amplitude ou en modulation de fréquence, ce signal de niveau de bruit étant appliqué à un circuit de comparaison qui actionne un circuit interrupteur pour couper le signal basse fréquence restitué par le récepteur lorsque le niveau de bruit dépasse un certain seuil.

On sait qu'en l'absence de signal à leur entrée, les récepteurs radio procurent à leur sortie un bruit qui est très gênant pour les opérateurs chargés d'assurer la veille sur une fréquence porteuse. Les dispositifs de silencieux (Squelch en anglais) ont pour but de couper la sortie basse fréquence du récepteur lorsqu'aucun signal de parole n'est reçu et inversement de la rétablir dès l'apparition du signal de parole.

Un certain nombre de dispositifs de silencieux utilisés dans les récepteurs à modulation de fréquence sont basés sur une mesure du niveau de bruit à la sortie du démodulateur de fréquence du récepteur, dans une bande de fréquence située au-dessus de la bande de fréquence utilisée pour le signal de parole. Le dispositif de silencieux connu, envisagé ci-dessus pour un récepteur fonctionnant en modulation de fréquence ou d'amplitude est basé sur la même mesure du niveau de bruit à la sortie du démodulateur de fréquence du récepteur, que le récepteur fonctionne en modulation de fréquence ou en modulation d'amplitude (voir par exemple le brevet US-A-3 728 634). Mais on a toutefois constaté, lorsque le récepteur reçoit un signal modulé en amplitude, une certaine sensibilité du dispositif de silencieux au taux de modulation, qui paraît engendrée par une augmentation du bruit fourni par le démodulateur de fréquence au-dessus d'un certain taux de modulation et qui peut se traduire par des coupures intempestives du signal de parole.

La présente invention a pour but de fournir un dispositif de silencieux évitant cet inconvénient.

Conformément à l'invention, le dispositif de silencieux est muni de plus d'un circuit de correction qui est connecté à la sortie du démodulateur AM et mis en service lorsque le récepteur est commandé pour fonctionner en modulation d'amplitude, ce circuit de correction comportant un circuit de détection des crêtes du signal basse fréquence dépassant un certain seuil d'une certaine polarité, qui est connecté à un circuit d'intégration pour fournir un signal de correction appliqué audit circuit de comparaison de façon à y produire un effet opposé à l'effet dudit signal de niveau de bruit.

La description suivante, en regard des dessins annexés, le tout donné à titre d'exemple, fera bien comprendre comment l'invention peut être réalisée.

La figure 1 est un schéma du dispositif de silencieux conforme à l'invention.

La figure 2 montre un mode de réalisation du circuit de correction incorporé dans ce dispositif de silencieux.

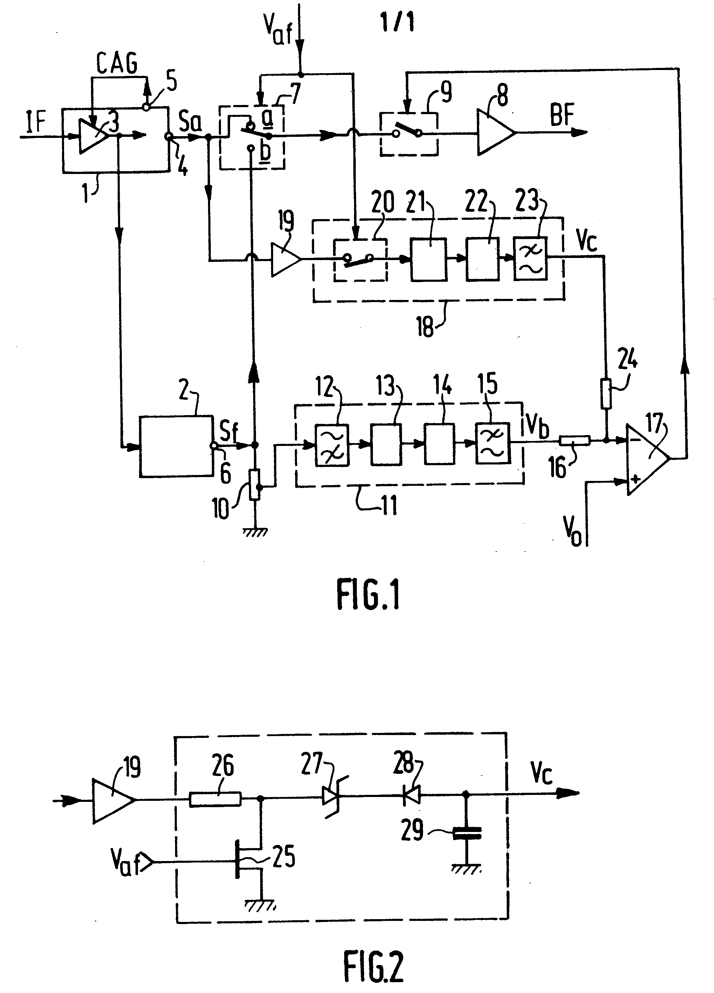

Sur la figure 1 qui montre le dispositif de silencieux de l'invention, on a représenté par la référence 1 le démodulateur d'amplitude (appelé par la suite démodulateur AM) et par la référence 2 le démodulateur de fréquence (démodulateur FM), ces deux démodulateurs étant incorporés dans un récepteur qui peut fonctionner en modulation de fréquence ou en modulation d'amplitude. Le signal à fréquence intermédiaire FI formé dans le récepteur est appliqué à un amplificateur de signal FI 3 qui est incorporé dans le démodulateur AM 1. Le signal FI amplifié est traité, de façon connue en soi, dans le démodulateur AM 1 qui fournit à sa sortie 4 un signal $S_a$ qui est le signal basse fréquence utile lorsque le récepteur reçoit un signal modulé en amplitude. Le démodulateur 1 fournit également à sa sortie 5 un signal CAG pour commander automatiquement le gain de l'amplificateur 3, de façon que l'amplitude du signal FI amplifié soit sensiblement constante. Le signal FI amplifié est traité également dans le démodulateur FM 2 qui fournit à sa sortie 6 un signal $S_f$ qui est le signal basse fréquence utile lorsque le récepteur reçoit un signal modulé en fréquence.

Le circuit commutateur 7 est commandé par le signal $V_{af}$ de sélection du mode de fonctionnement du récepteur pour être établi sur la position a ou sur la position b selon que le mode de fonctionnement choisi est la modulation d'amplitude ou la modulation de fréquence. Le circuit commutateur 7 dirige donc le signal démodulé basse fréquence $S_a$ ou $S_f$ vers l'amplificateur 8 qui fournit le signal BF de sortie du récepteur.

Lorsque aucun signal n'est reçu à l'entrée du récepteur, les démodulateurs 1 ou 2 engendrent un signal de bruit de niveau élevé qui, transmis à la sortie du récepteur, est très gênant pour l'opérateur. Le dispositif de silencieux comprend un circuit interrupteur 9 qui doit être commandé pour couper ou établir le circuit de sortie du récepteur selon qu'un signal est absent ou présent à l'entrée du récepteur.

Dans le type de dispositif de silencieux que l'invention propose d'améliorer, la commande du circuit interrupteur 9 est effectuée à partir d'une mesure du niveau de bruit à la sortie du démodulateur FM 2, ce niveau de bruit étant élevé en l'absence de signal à l'entrée du récepteur ou pour des niveaux faibles du signal utile. Pour la mesure de ce niveau de bruit, on utilise un potentiomètre 10 pour prélever une fraction du signal à la sortie 6 du démodulateur 2. Ce signal prélevé est traité dans le circuit 11 qui comporte à son entrée un filtre 12 qui peut être par exemple du type passe-haut pour transmettre des fréquences en dehors de la bande 300–3400 Hz du signal utile. Les impulsions du signal filtré sont écrêtées et détectées dans les circuits 13 et 14 et enfin intégrées dans le filtre passe-bas 15. Ce dernier fournit une tension continue $V_b$ qui est appliquée à une borne de la résistance 16 dont l'autre borne est connectée à l'entrée inverseuse du circuit comparateur 17. Ce dernier reçoit sur son entrée non inverseuse une tension constante $V_o$. Quand la tension continue $V_b$, représentative du niveau du bruit à la sortie du démodulateur 2, dépasse une tension de seuil déterminée par la tension $V_o$, le signal logique fourni par le circuit comparateur 17 change de valeur de façon à ouvrir le circuit interrupteur 9, ce qui coupe le circuit basse fréquence du récepteur, l'inverse se produisant quand la tension $V_b$ revient au-dessous de ladite tension de seuil.

Mais, comme on l'a expliqué, ce dispositif de silencieux peut présenter un défaut lorsque le récepteur reçoit un signal modulé en amplitude, avec un taux de modulation élevé d'au moins 50% environ. Dans ces conditions, dans les «creux» du signal modulé pour lesquels le niveau instantané du signal FI tombe au-dessous du seuil du limiteur du démodulateur FM 2, ce démodulateur engendre un certain bruit qui, après son traitement dans le circuit 11, peut être suffisant pour déclencher intempestivement la coupure du circuit basse fréquence du récepteur.

Pour pallier ce défaut, le dispositif de silencieux est muni, suivant l'invention, d'un circuit de correction 18 qui élabore un signal de correction $V_c$ apte à corriger de façon adéquate le signal de niveau de bruit $V_b$.

Le circuit de correction 18 est connecté à la sortie de l'amplificateur 19 amplifiant le signal de sortie du démodulateur AM 1, ce signal de sortie étant le signal de modulation lorsque la porteuse est modulée en amplitude. Le circuit de correction 18 comporte un circuit interrupteur 20 qui est commandé par le signal de sélection $V_{af}$ de façon à diriger le signal de sortie de l'amplificateur 19 vers le circuit à seuil 21, seulement lorsque le mode de fonctionnement choisi est la modulation d'amplitude. Le circuit à seuil 21 est associé à un circuit de détection 22 pour détecter les crêtes négatives du signal fourni par l'amplificateur 19 dépassant un seuil négatif. Lorsque le récepteur reçoit une porteuse modulée en amplitude, les impulsions négatives ainsi formées se produisent pendant les crêtes négatives du signal de modulation dépassant un seuil négatif, c'est-à-dire pendant les creux du signal modulé, au-dessus d'un certain taux de modulation correspondant audit seuil. Les impulsions négatives fournies par le détecteur 22 sont intégrées à l'aide du filtre passe-bas 23 qui fournit la tension de correction $V_c$. Cette tension de correction $V_c$ est appliquée à une borne de la résistance 24 dont l'autre borne est connectée à l'entrée inverseuse du circuit comparateur 17.

La tension de correction $V_c$ corrige l'effet de la tension de niveau de bruit $V_b$ dans un sens tendant à augmenter l'écart entre la tension appliquée sur l'entrée inverseuse du circuit comparateur 17 et la tension fixe $V_o$ appliquée sur l'entrée non inverseuse. Cette tension de correction n'existe que lorsque le mode de fonctionnement du récepteur est la modulation d'amplitude avec un taux de modulation dépassant un seuil déterminé par le circuit à seuil 21. On peut éviter ainsi les déclenchements intempestifs du dispositif de silencieux.

La figure 2 représente un mode de réalisation simple du circuit de correction 18. Ce circuit 18 comporte à l'entrée un transistor 25 du type J.FET canal P dont la grille est commandée directement par la tension de sélection $V_{af}$ et qui permet de court-circuiter la tension de modulation fournie par l'amplificateur 19 à travers la résistance d'isolement 26. Lorsque le mode de fonctionnement choisi est la modulation d'amplitude, la tension de modulation est appliquée à la diode Zener 27 montée en série tête-bêche avec la diode 28. Ce montage 27, 28 est l'équivalent d'une diode ayant la tension de seuil $V_Z$ de la diode Zener 27 et fournit ainsi les crêtes négatives dépassant le seuil négatif $-V_Z$. Ces crêtes négatives sont intégrées à l'aide du condensateur 29 dont une électrode est reliée à la masse et dont l'autre électrode reliée à la diode 28 fournit la tension de correction $V_c$.

**Revendications**

1. Dispositif de silencieux pour récepteur radio muni d'un démodulateur AM et d'un démodulateur FM pour le fonctionnement du récepteur en modulation de fréquence ou en modulation d'amplitude, ce dispositif de silencieux comportant un circuit de mesure du niveau de bruit connecté à la sortie du démodulateur FM pour fournir un signal de niveau de bruit lors du fonctionnement du récepteur en modulation d'amplitude ou en modulation de fréquence, ce signal de niveau de bruit étant appliqué à un circuit de comparaison qui actionne un circuit interrupteur pour couper le signal basse fréquence restitué par le récepteur lorsque le niveau de bruit dépasse un certain seuil, caractérisé en ce que le dispositif de silencieux est muni de plus d'un circuit de correction qui est connecté à la sortie du démodulateur AM et mis en service lorsque le récepteur est commandé pour fonctionner en modulation d'amplitude, ce circuit de correction comportant un circuit de détection des crêtes du signal basse fréquence dépassant un certain seuil d'une certaine polarité, qui est connecté à un circuit d'intégration pour fournir un signal de correction appliqué audit circuit de comparaison de façon à y produire un effet opposé à l'effet dudit signal de niveau de bruit.

2. Dispositif de silencieux selon la revendication 1, caractérisé en ce que le circuit de correction comporte un transistor qui est commandé par le signal de sélection du mode de fonctionnement du récepteur et qui, lorsque le mode de fonctionnement choisi est la modulation d'amplitude, transmet le signal de sortie du démodulateur AM, au montage en série tête-bêche d'une diode Zener et d'une diode, la sortie dudit montage en série étant connectée à un condensateur d'intégration qui fournit le signal de correction.

## Patentansprüche

1. Rauschsperre für Rundfunkempfänger mit einem AM-Demodulator und einem FM-Demodulator für den AM- bzw. FM-Betrieb des Empfängers, wobei diese Rauschsperre eine Rauschpegelmessschaltung aufweist, die mit dem Ausgang des FM-Demodulators verbunden ist zum Liefern eines Rauschpegelsignals wenn der Empfänger in der AM- oder FM-Betriebsart arbeitet, wobei dieses Rauschpegelsignal einer Vergleichsschaltung zugeführt wird, die eine Unterbrecherschaltung aktiviert zum Sperren des Tonfrequenzsignals, das von dem Empfänger wiedergegeben wird, wenn der Rauschpegel eine bestimmte Schwelle überschreitet, dadurch gekennzeichnet, dass die Rauschsperre ausserdem mit einer Korrekturschaltung versehen ist, die mit dem Ausgang des AM-Demodulators verbunden und wirksam ist, wenn der Empfänger zum Funktionieren in der AM-Betriebsart gesteuert wird, wobei diese Korrekturschaltung eine Detektionsschaltung aufweist zum Detektieren von Spitzen des Tonfrequenzsignals, die eine bestimmte Schwelle einer bestimmten Polarität überschreiten, wobei diese Detektionsschaltung mit einer Integrationsschaltung verbunden ist zum Liefern eines Korrektursignals, das der genannten Vergleichsschaltung zugeführt wird, damit ein dem Effekt des genannten Rauschpegelsignals entgegengesetzter Effekt erzeugt wird.

2. Rauschsperre nach Anspruch 1, dadurch gekennzeichnet, dass die Korrekturschaltung einen Transistor aufweist, der durch das Betriebsartwahlsignal des Empfängers gesteuert wird und, wenn die gewählte Betriebsart die Amplitudenmodulation ist, das Ausgangssignal des AM-Demodulators zu einer Kopf-Schwanz-Reihenschaltung aus einer Zener-Diode und einer Diode weiterleitet, wobei der Ausgang der genannten Reihenschaltung mit einem das Korrektursignal liefernden Integrationskondensator verbunden ist.

## Claims

1. A squelch arrangement for radio receivers comprising an AM demodulator and an FM demodulator for amplitude-modulation or frequency-modulation operation of the receiver, this squelch arrangement comprising a noise level measuring circuit connected to the output of the FM demodulator for supplying a noise level signal when the receiver operates in the amplitude-modulation mode or in the frequency-modulation mode, this noise level signal being applied to a comparison circuit which activates an interrupter circuit for muting the low-frequency signal recovered by the receiver when the noise level exceeds a certain threshold, characterized in that the squelch arrangement comprises more than one correction circuit which is connected to the output of the AM demodulator and activated when the receiver is commanded to operate in the amplitude-modulation mode, this correction circuit comprises a circuit for detecting peaks of the low-frequency signal exceeding a certain threshold of a certain polarity, which circuit is connected to an integrating circuit for supplying a correction signal which is applied to the said comparison circuit in such a manner as to produce there an effect opposite to the effect of the said noise level signal.

2. A squelch arrangement as claimed in Claim 1, characterized in that the correction circuit comprises a transistor which is controlled by the operating mode selection signal of the receiver and, when the chosen operating mode is the amplitude-modulation mode, passes the output signal of the AM demodulator, to the series-connected arrangement of a head to tail configuration of a zener diode and a diode, the output of the said series arrangement being connected to an integrating capacitor which supplies the correction signal.

FIG.1

FIG.2